# EUROPÄISCHE PATENTSCHRIFT

(11) **EP 2 748 653 B1**
(45) Veröffentlichungstag und Bekanntmachung des Hinweises auf die Patenterteilung: **13.01.2016**
(21) Anmeldenummer: 12784060.1
(22) Anmeldetag: 22.08.2012
(51) Int. Cl.: G02B 1/00, B81C 1/00, G02B 6/13, B82Y 20/00, G02B 6/122

(54) **VERFAHREN ZUR HERSTELLUNG PERIODISCHER KRISTALLINER SILIZIUM-NANOSTRUKTUREN**
METHOD FOR PRODUCING PERIODIC CRYSTALLINE SILICON NANOSTRUCTURES
PROCÉDÉ DE PRODUCTION DE NANOSTRUCTURES DE SILICIUM PÉRIODIQUES CRISTALLINES

(30) Priorität: 25.08.2011 DE 102011111629
(43) Veröffentlichungstag der Anmeldung: 02.07.2014
(73) Patentinhaber: Helmholtz-Zentrum Berlin für Materialien und Energie GmbH, 14109 Berlin (DE)
(72) Erfinder: BECKER, Christiane, 10247 Berlin (DE); SONTHEIMER, Tobias, 10245 Berlin (DE); BOCKMEYER, Matthias, 55116 Mainz (DE); RUDIGIER-VOIGT, Eveline, 55128 Mainz (DE); RECH, Bernd, 12587 Berlin (DE)
(86) Internationale Anmeldenummer: PCT/IB2012/001989
(87) Internationale Veröffentlichungsnummer: WO 2013/027123

(56) Entgegenhaltungen:
- EP-A1- 0 964 305
- WO-A2-2004/008200
- KAWAKAMI S: "Fabrication of submicrometre 3D periodic structures composed of Si/SiO<E7>2</E7>", ELECTRONICS LETTERS, IEE STEVENAGE, GB, Bd. 33, Nr. 14, 3. Juli 1997 (1997-07-03), Seiten 1260-1261, XP006007701, ISSN: 0013-5194, DOI: 10.1049/EL:19970844
- KAWAKAMI SHOJIRO ET AL: "Mechanism of shape formation of three-dimensional periodic nanostructures by bias sputtering", APPLIED PHYSICS LETTERS, AIP, AMERICAN INSTITUTE OF PHYSICS, MELVILLE, NY, US, Bd. 74, Nr. 3, 18. Januar 1999 (1999-01-18), Seiten 463-465, XP012023087, ISSN: 0003-6951, DOI: 10.1063/1.123037

## Beschreibung

Die Erfindung betrifft ein Verfahren zur Herstellung periodischer kristalliner Silizium-Nanostrukturen gemäß Anspruch 1, aufweisend mindestens die Verfahrensschritte Erzeugen eines periodisch strukturierten Substrats mit einer Gitterkonstante a zwischen 100 nm und 2 µm und anschließendes Abscheiden von α-Silizium mittels eines gerichteten Abscheideverfahrens auf das periodisch strukturierte Substrat, wobei als Substrat ein bis mindestens 570 °C stabiles Material verwendet und die Struktur mit periodisch wiederkehrenden flachen und steilen Gebieten/Flanken erzeugt wird.

Periodische Nanostrukturen - im Besonderen photonische Kristalle - können Licht auf Abmessungen, welche in der Größenordnung der Wellenlänge des Lichts liegen, führen, filtern und wellenlängenselektiv reflektieren. Sie sind deshalb die Basis für photonische Komponenten, in denen die Informationsüber-tragung mittels Licht funktioniert.

Die Herstellung von photonischen Kristallen ist jedoch eine Herausforderung an die Technologen, da bei diesen Materialen der Brechungsindex räumlich periodisch auf der Skala der Lichtwellenlänge, also im Submikrometerbereich, variieren muss. Dabei ist ein großer Brechungsindexkontrast, wie z.B. zwischen Silizium oder III-V-Halbleitern, und Luft von besonderem Vorteil. Zudem ist das Material Silizium für photonische Anwendungen aufgrund des geringen Preises, seiner Ungiftigkeit, des großen nichtlinearen Brechungsindex und der Kompatibilität mit vorhandener Si-Wafer-Technologie sehr beliebt.

Aufgrund der Strukturgrößen im Submikrometerbereich basieren bisher die meisten der Herstellungsprozesse zweidimensionaler photonischer Kristalle auf Lithographietechniken, wodurch die maximale Ausdehnung dieser Materialien meist im Submillimeterbereich liegt und die Herstellung sehr aufwändig ist. Es wurden lediglich Probengrößen von maximal einigen Quadratzentimetern hergestellt, wobei aufgrund zu großer Strukturgrößen jedoch nicht der interessierende Lichtwellenlängenbereich im Sichtbaren oder Nahen Infrarot (NIR) bei "Telekommunikationswellenlängen", d.h. 1,33 µm und 1,5 µm erreicht wurde.

Die großflächigsten Materialien mit einigen Quadratzentimetern Fläche werden dem Stand der Technik nach durch die Anwendung von Elektronenstrahl-Lithographie oder Nano-Indentation und anschließendem Ätzen hergestellt. Allerdings liegen in den meisten Fällen die photonischen Bandlücken nicht im sichtbaren oder nahen Inrarotwettenlängenbereich.

In Adv. Mater. 2005, 17, 2103-2106 ist ein zweistufiges Verfahren zur Herstellung photonischer Kristalle aus Luft/TiO₂/Nanostäben beschrieben. Bei diesem Verfahren wird in einem ersten Schritt ein kontinuierliches hexagonales Muster aus Gold-Nanopartikeln auf einem Saphir-Substrat gebildet. Dieses Gold-Muster wirkt dann in einem Aufwachsprozess als Katalysator für die entstehenden ZnO-Nanostäbe, wobei dieser Prozess in einem Ofen bei erhöhter Temperatur ausgeführt wird. Die Höhe und der Durchmesser der ZnO-Nanostäbe werden durch die Dicke der als Katalysator wirkenden Goldschicht und der Aufwachszeit bestimmt. In einem zweiten Schritt werden die ZnO-Nanostäbe einheitlich mit einer dielektrischen TiO₂-Schicht, die mittels eines Niedrigtemperatur-ALD-Prozesses aufgebracht wird. Die TiO₂-beschichteten ZnO-Nanostäbe bilden einen photonischen Kristall, der laut Simulation eine Bandlücke bei einer Wellenlänge von 2,3 µm aufweist. Allerdings müsste die Periode dieser Strukturen noch knapp um Faktor Zwei kleiner sein, damit die berechnete Bandlücke im interessierenden Telekommunikationswellenlängen-Bereich von 1,33 µm bzw. 1,5 µm oder im Sichtbaren liegt. Zudem beträgt der effektive Brechungsindex der TiO₂-beschichteten ZnO-Strukturen nur 2,2. Bei photonischen Kristallen aus Silizium oder III-V-Halbleitern, wie z.B. GaAs, sind aufgrund ihres wesentlich höheren Brechnungsindex wesentlich größere Bandlücken möglich.

Ein Verfahren zur Herstellung einer zweidimensionalen photonischen Bandstruktur basierend auf makroporösem Silizium ist in Appl. Phys. Lett. 68 (6), 5 February 1996, pp. 756-758, von Y.-K. Kim et al. beschrieben. In diesem Verfahren werden zunächst mittels eines elektrochemischen Prozesses Poren in regulärer Anordnung mit einem Durchmesser im Mikrometerbereich und einer Tiefe von einigen Hundert µm im Silizium gebildet. Anschließend werden mittels mikromaschineller Bearbeitung Si-Säulen aus diesem porösen Material mit steilen Seitenwänden gebildet. Diese Technik kann für die Herstellung photonischen Materials mit einem Bandgap im IR-Bereich bei einer Wellenlänge von 5 µm genutzt werden. Allerdings müssten die Strukturgrößen noch um den Faktor 3 bis 4 kleiner sein, damit die Bandlücke im technologisch interessanten sichtbaren oder NIR Bereich liegt.

Ein Verfahren, bei dem ein dünner polykristalliner Silizium-Film mittels Elektronenstrahlverdampfung und anschließender thermischer Behandlung auf ein mit ZnO: Al beschichtetes Glassubstrat aufgebracht wird, ist in J. Appl. Phys. 106, 084506 (2009) beschrieben. Bei diesem Verfahren wurden in Abhängigkeit des Temperaturregimes als Ergebnis der Elektronenstrahlverdampfung bei Depositionstemperaturen < 400 °C und anschließender Temperaturbehandlung als Kristallisationsschritt 1 bis 3 µm große Körner mit zufälliger Orientierung beobachtet, eine Elektronenstrahlverdampfung von Si bei Temperaturen > 400 °C kristallisieren direkt in Stäben (reveal columnar), bis 200 nm große Kristalle mit einer strengen <110> Orientierung. Diese Kristallite zeigen bessere Solarzellenparameter als die Körner, hergestellt bei Temperaturen < 400 °C.

Auch in 24th European Photovoltaic Solar Energy Conference, 21-25 September 2009, Hamburg, Germany, 2482-2485 wird Silizium mittels Elektronenstrahlverdampfung auf verschieden texturierte Gläser aufgebracht und deren Morphologie, Wachstum und Defektstruktur untersucht. Ebenfalls in einem anderen Paper, das in den Proceedings der eben erwähnten Konferenz auf den S. 2279 bis 2285, erschienen ist, wird über die Elektronenstrahlverdampfung von dünnen Siliziumschichten auf texturierten Glassubstraten berichtet.

In Solar Energy 77 (2004) 857-863 wird ein Solarzellen-Konzept beschrieben, das auf kristallinen, dünnen Siliziumschichten auf Glas als billigem Substrat basiert. Die Herstellung der Schichten erfolgt durch Dampfphasenabscheidung von amorphem Silizium and anschließender Festphasenkristallisation durch thermisches Heizen bei etwa 600°C. In dem Konzept werden die Vorteile traditioneller Si-Wafertechnologie, wie die hohe Materialqualität sowie die Ungiftigkeit und hohe Verfügbarkeit von kristallinem Silizium, mit den Vorzügen von Dünnschichttechnologien vereint, zu denen neben einem geringen Materialverbrauch auch die Möglichkeit einer integrierten Serienverschaltung der Solarzellen auf großen Flächen gehört. In den Proceedings der 35th IEEE Photovoltaic Specialists Conference, 20-25 Juni 2010, Hawaii, USA, 614-619, wird zudem gezeigt, dass mittels Elektronenstrahlverdampfung, einem gerichteten Hochratendepositionsverfahren, abgeschiedene und anschließend thermisch festphasenkristallisierte kristalline Siliziumschichten zu vergleichbaren Solarzelleneffizienzen führen.

Dem Stand der Technik nach sind auch verschiedene Verfahren zur Strukturierung von Substraten bekannt. So wird in 24th European Photovoltaic Solar Energy Conference, 21-25 September 2009, Hamburg, Germany, 2884-2886 eine Strukturierung der Frontelektrode in Si-basierten Dünnschichtfilmen mittels Sol-Gel-Verfahren beschrieben. Über diese Methode wird auch in DE 10 2005 036 427 A1 zur Herstellung einer voll- oder teilflächig makrostrukturierten Schicht auf einem Substrat berichtet.

Eine Mikrostrukturierung von Substraten aus Flachglas ist in DE 10 2004 049 233 A1 beschrieben, bei der eine Substratoberfläche mit wenigstens einer strukturierten Maskierschicht beschichtet und anschließend einem chemisch reaktiven Ionenätzverfahrens mit wenigstens einem chemischen Ätzgas ausgesetzt wird.

Bei dem in WO 2004/008200 A2 beschriebenen Verfahren zur Herstellung optischer Wellenleiterstrukturen werden die stabförmigen Strukturen durch Ätzen der Kernschicht erzeugt, deren Position mittels Direktschreiben mit einem Elektronenstrahl oder einer Maske übertragen wurden. In die erzeugten Löcher wird Silizium mittels PECVD, CVD, MBE und Sputtern eingebracht. Anschließend ist ein weiterer Lithographieschritt notwendig, um die Wellenleiter zu definieren. Ein weiteres Verfahren zur Erzeugung eines photonischen Kristalls ist in EP 0 964 305 A1 beschrieben. Bei diesem Verfahren werden gekreuzte Gitter durch Mehrfach-Belichtungsprozesse mittels Laserinterferenz erzeugt. Beide erwähnten Verfahren sind aber sehr aufwendig.

In ELECTRONIC LETTERS, IEE STEVENAGE, GB, Bd. 33, Nr. 14, 3. Juli 1997, S. 1260-1261 und in APPLIED PHYSICS LETTERS, AIP, AMERICAN INSTUTE OF PHYSICS, MELVILLE, NY, US, Bd. 74, Nr. 3, 18. Januar 1999, S. 463-465 wird die Erzeugung einer dreidimensionalen periodischen Nanostruktur in Form eines Vielschichtsystems beschrieben, das jedoch keine kristalline Silizium-Schicht aufweist. Zunächst werden periodisch angeordnete Löcher auf einem Substrat mittels Elektronenstrahllithographie erzeugt. Darauf werden abwechselnd a-Silizium-Schichten und SiO₂-Schichten mittels eines gerichteten Abscheideverfahrens aufgebracht. Mit dem dort beschriebenen Verfahren soll die Abflachung der periodischen Struktur in einem Vielschichtsystem verhindert werden.

Dem Stand der Technik nach ist bisher kein Verfahren bekannt, mit dem periodische kristalline Silizium-Nanostrukturen mit einer Periodizität unter 2 µm preisgünstig und großflächig herstellbar sind.

Aufgabe der Erfindung ist es deshalb, ein solches preisgünstiges Verfahren zur Herstellung großflächiger periodischer kristalliner Silizium-Nanostrukturen mit einer Periodizität unter 2 µm anzugeben.

Die Aufgabe wird durch ein Verfahren der eingangs genannten Art dadurch gelöst, dass das Silizium auf das periodisch strukturierte Substrat mit einer Dicke im Bereich vom 0,2- bis 3-fachen der Gitterkonstante - also von 40 nm bis 6 µm - bei einer Substrattemperatur von bis zu 400 °C abgeschieden und danach die abgeschiedene Si-Schicht zwecks Festphasenkristallisation bei Temperaturen zwischen 570 °C und 1.400 °C über wenige Minuten bis zu mehreren Tagen thermisch behandelt wird.

Das einfache und kostengünstige Verfahren ermöglicht die Herstellung kristalliner Si-basierter zweidimensionaler photonischer Kristalle auf großen Flächen. Gleichzeitig sind Strukturgrößen bis hinunter zu 200 nm möglich, so dass sich die photonischen Bandlücken im gewünschten sichtbaren und NIR-Wellenlängenbereich befinden.

In einer Ausführungsform der Erfindung wird als Substrat ein Glassubstrat verwendet. Es kann aber auch jedes andere Substrat verwendet werden, das Temperaturen von mehr als 570°C aushält und periodisch wiederkehrende flache und steile Gebiete aufweist. Als "flach" werden Gebiete bezeichnet und im Zusammenhang mit der Erfindung verstanden, deren Flächennormale einen Winkel kleiner 20° mit der Flächennormale eines planaren Substrats einschließt. Als "steil" werden Gebiete bezeichnet, deren Flächennormale einen Winkel größer 35° mit der Flächennormale eines planaren Substrats einschließt.

In einer Ausführungsform werden in einem optionalen Verfahrensschritt die entstandenen porösen Si-Gebiete durch nasschemisches selektives Ätzen der Si-Schichten entfernt. Da nanokristallines, poröses Silizium durch Säuren jeglicher Art wesentlich schneller geätzt wird als die kompakten kristallinen Silizium-Gebiete, sind bei entsprechender Wahl der jeweiligen Säuren und geeigneter Einstellung der Ätzzeit frei stehende Silizium-Kristalle das Ergebnis. Dem Durchschnittsfachmann sind derartige Ätzverfahren aus dem Stand der Technik bekannt.

Als gerichtetes Abscheideverfahren wird in einer weiteren Ausführungsform die Elektronenstrahlverdampfung eingesetzt. Jegliche Art von thermischem Verdampfen für die Abscheidung von Si auf die flachen und steilen Flanken der Substratstruktur ist möglich. Weniger geeignet sind konformale Abscheideverfahren, wie z.B. Dampfphasenepitaxie. Durch die Textur des Substrats trifft das Silizium bei gerichteter Abscheidung mit unterschiedlichen Winkeln auf die Oberfläche. Je nach Substrattemperatur während der Abscheidung wächst das Silizium in amorpher oder teilkristalliner Phase auf.

Während der thermischen Behandlung zwecks Festphasenkristallisation des Siliziums kommt es zur Ausbildung von zwei Silizium-Phasen. In flachen Gebieten des Substrats, d.h. bei nahezu senkrechtem Auftreffen des Siliziums auf die Oberfläche, bildet sich kristallines Silizium aus. Auf steilen Flanken der Textur wächst jedoch poröses, nanokristallines Material.

Die Erfindung soll in folgendem Ausführungsbeispiel anhand von Figuren näher erläutert werden. Dabei zeigen
- Figur 1:: SEM-Aufnahme eines periodisch strukturierten Glassubstrats;
- Figur 2:: TEM-Aufnahme einer gemäß erfindungsgemäßem Verfahren hergestellten Silizium-Schicht nach thermischer Kristallisation;
- Figur 3:: SEM-Aufnahme einer gemäß erfindungsgemäßem Verfahren hergestellten Silizium-Schicht nach Entfernen der porösen Gebiete durch selektives Ätzen;
- Figur 4:: SEM-Aufnahmen gemäß erfindungsgemäßem Verfahren hergestellter Silizium-Schichten nach Entfernen der porösen Gebiete durch selektives Ätzen für verschieden lange Ätzdauern;
- Figur 5:: Winkelaufgelöste Reflexionsspektren -mit p-polarisiertem Licht an den erfindungsgemäß hergestellten periodischen Nanostrukturen;
- Figur 6:: 2D simulierte und aus den winkelaufgelösten Reflexionsmessungen aus Figur 5 experimentell ermittelte photonische Bandstruktur von erfindungsgemäß hergestellten periodischen Nanostrukturen.

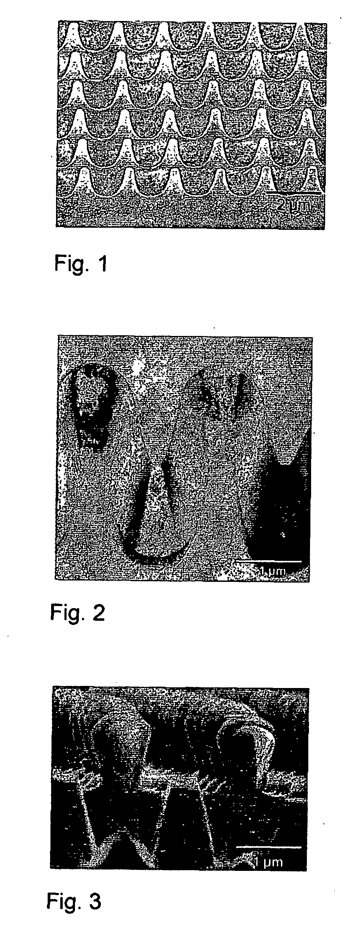

In dem folgenden Ausführungsbeispiel zur Herstellung von zweidimensionalen periodischen Nanostrukturen wird ein Glassubstrat mit einer periodischen Struktur verwendet, die eine quadratische Gitterordnung und Gitterkonstanten von 300 nm oder 2 µm aufweist. Diese Gläser wurden mittels Nanoimprint-Verfahren hergestellt, das bereits im Stand der Technik gewürdigt wurde (siehe 24th European Photovoltaic Solar Energy Conference, 21-25 September 2009, Hamburg, Germany, pp. 2884). In Fig. 1 ist eine SEM-Aufnahme eines solchen periodisch strukturierten Glassubstrats zu sehen. Zu erkennen ist die Struktur mit periodisch wiederkehrenden flachen und steilen Gebieten/Flanken.

Anschließend wird auf das strukturierte Glassubstrat bei einer Substrattemperatur von 300 °C eine 1,4 µm dicke Silizium-Schicht mittels Elektronenstrahlverdampfung abgeschieden.

Im Anschluss daran wird die aufgebrachte Si-Schicht, die amorph oder teilkristallin abgeschieden wurde, im nächsten Verfahrensschritt durch 20-stündiges Heizen bei 600 °C komplett festphasenkristallisiert. Es kommt zur Ausbildung von zwei Silizium-Phasen. In flachen Gebieten des Substrats, d.h. dort, wo das Silizium nahezu senkrecht auf die Oberfläche auftrifft, bildet sich kompaktes, kristallines Silizium aus. Auf steilen Flanken der Textur wächst jedoch poröses, nanokristallines Material. Dies ist in Figur 2 durch die entsprechende TEM-Aufnahme gezeigt.

In diesem Ausführungsbeispiel wird abschließend der optionale Verfahrensschritt des selektiven nasschemischen Ätzens durchgeführt. Dabei wird das nanokristalline, poröse Silizium an den steilen Flanken der Strukturen durch eine Lösung bestehend aus einem Anteil 50% konzentrierter Fluss-, 30 Anteilen 65 % konzentrierter Salpetersäure, 10 Anteilen 85% konzentrierter Phosphorsäure und 15 Anteilen Wasser entfernt. Da das poröse Material wesentlich schneller geätzt wird als die kompakten, kristallinen Silizium-Gebiete, entstehen bei entsprechender Einstellung der Ätzzeit, typisch sind 40 bis 90 Sekunden bei Schichtdicken von 300 nm bis 1,5 µm, freistehende Silizium-Kristalle. Eine SEM-Aufnahme dieser Silizium-Strukturen ist in Figur 3 gezeigt. Die mit dem erfindungsgemäßen Verfahren hergestellten freistehenden Strukturen weisen die folgenden Abmessungen auf: Höhe 1,4 µm, Durchmesser von 0,3 µm bis zu 0,8 µm. Die Si-Nanostrukturen wurden in diesem Ausführungsbeispiel auf einer Fläche von 10 x10 cm² erzeugt. Das erfindungsgemäße Verfahren ist aber auch auf größere Flächen skalierbar.

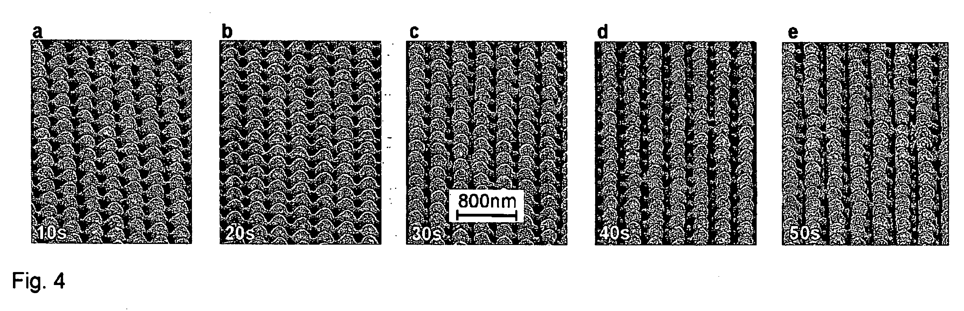

Durch die Einstellung der Ätzzeit kann der Durchmesser der freistehenden Silizium-Strukturen variiert werden. Eine Serie von SEM-Bildern von verschieden lang geätzten Silizium-Strukturen (Ätzzeit im jeweiligen Bild angegeben) ist in Figur 4 zu sehen. Die Periodizität beträgt in diesem Fall 300 nm, die Si-Schichtdicke 235 nm.

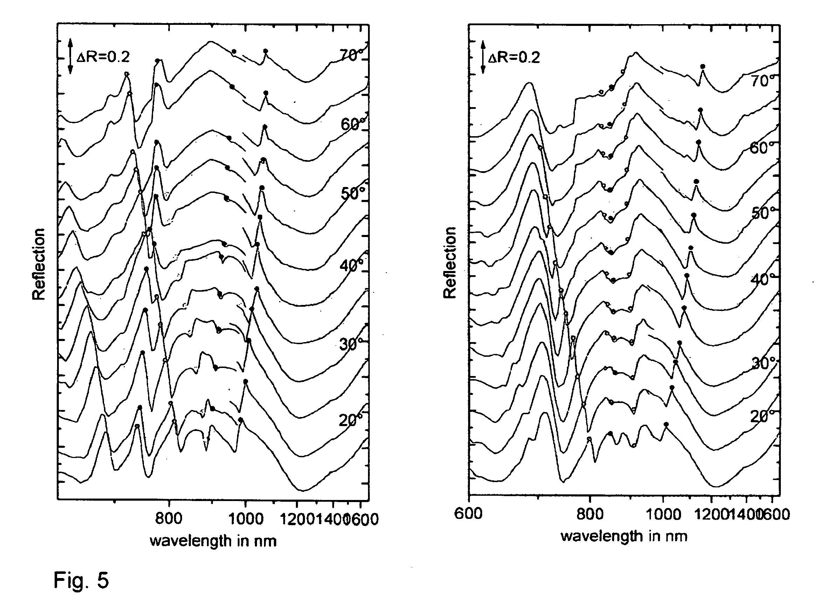

In Figur 5 sind winkelaufgelöste Reflexionsmessungen entlang der beiden Hochsymmetrierichtungen an nach erfindungsgemäßem Verfahren hergestellten periodischen Silizium-Nanostrukturen zu sehen. Die Strukturen haben eine Periodizität von 300 nm und eine Schichtdicke von 270 nm. Der optionale Ätzschritt wurde bei diesen Strukturen nicht angewendet. Das einfallende Licht war p-polarisiert. Nach Phys. Rev. B 60 (24), R16255, 1999 erscheinen in den Reflexionsspektren scharfe Resonanzen, die photonischen Bändern der Struktur zugeordnet werden können. In Figur 5 sind diese Resonanzen durch Kreise markiert.

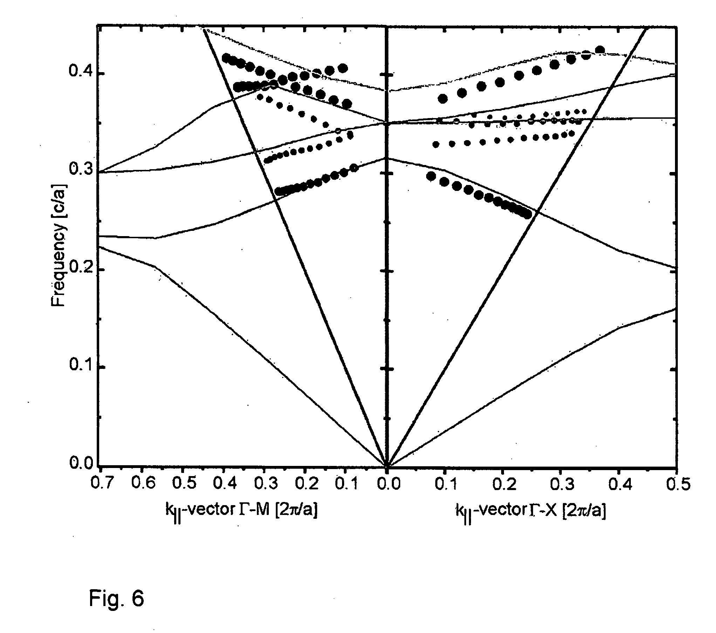

In Figur 6 sind die in Figur 5 experimentell ermittelten Resonanzen als photonische Bandstruktur zusammengefasst (ausgefüllte Kreise). Zusätzlich ist die durch 2D-Simulationen berechnete Bandstruktur periodisch angeordneter Silizium-Säulen angegeben. Daraus wird ersichtlich, dass die Strukturen ein photonisches Stoppband in Gamma-X-Richtung bei einer Frequenz von ca. 0,19 c/a (wobei c die Vakuumgeschwindigkeit des Lichts und a die Gitterkonstante ist) haben, was bei einer Periodizität von a = 300nm einer Wellenlänge von 1,55 µm entspricht, also genau einer gewünschten Telekommunikationswellenlänge.

## Patentansprüche

1. Verfahren zur Herstellung periodischer kristalliner Silizium-Nanostrukturen, aufweisend mindestens die Verfahrensschritte Erzeugen eines periodisch strukturierten Substrats mit einer Gitterkonstante a zwischen 100 nm und 2 µm und anschließendes Abscheiden von Silizium mittels eines gerichteten Abscheideverfahrens auf das periodisch strukturierte Substrat, wobei als Substrat ein bis mindestens 570 °C stabiles Material verwendet und die Struktur mit periodisch wiederkehrenden flachen und steilen Gebieten/Flanken erzeugt wird,
wobei das Silizium mit einer Dicke im Bereich vom 0,2- bis 3-fachen der Gitterkonstante a bei einer Substrattemperatur von bis zu 400 °C auf dem periodisch strukturierten Substrat abgeschieden wird und **dadurch gekennzeichnet, dass** danach die abgeschiedene Silizium-Schicht zwecks Festphasenkristallisation bei Temperaturen zwischen 570 °C und 1.400 °C über wenige Minuten bis zu mehreren Tagen thermisch behandelt wird.

2. Verfahren nach Anspruch 1,
**dadurch gekennzeichnet, dass**
die Si-Schicht zwecks Entfernen der entstandenen porösen Si-Gebiete im Anschluss an die thermische Behandlung zwecks Festphasenkristallisation nasschemisch selektiv geätzt wird.

3. Verfahren nach mindestens einem der vorangehenden Ansprüche,
**dadurch gekennzeichnet, dass**
als Substrat ein Glassubstrat verwendet wird.

4. Verfahren nach Anspruch 1,
**dadurch gekennzeichnet, dass**
als gerichtetes Abscheideverfahren die Elektronenstrahlverdampfung eingesetzt wird.

## Claims

1. A process for preparing periodic crystalline silicon nanostructures, comprising at least the process steps of generating a periodically structured substrate having a lattice constant a between 100 nm and 2 µm and then depositing silicon by means of a directional deposition method onto the periodically structured substrate, wherein a material which is stable up to at least 570 °C is used as substrate and the structure is produced with periodically alternating flat and steep regions/flanks, wherein the silicon having a thickness in the range of 0.2 to 3 times the lattice constant a is deposited at a substrate temperature of up to 400 °C on the periodically structured substrate and **characterized in that** thereafter the deposited silicon layer is thermally treated at temperatures between 570 °C and 1400°C for a few minutes up to a few days for solid phase crystallization.

2. The process according to claim 1, **characterized in that** following the thermal treatment for solid phase crystallization, the Si layer is selectively etched in a wet chemical process to remove the porous Si regions formed.

3. The process according to any one of the preceding claims, **characterized in that** a glass substrate is used as the substrate.

4. The process according to claim 1, **characterized in that** electron beam evaporation is used as a directed deposition method.

## Revendications

1. Procédé de fabrication de nanostructures cristallines périodiques en silicium, présentant au moins les étapes de procédé consistant à générer un substrat structuré périodique avec une constante de réseau a comprise entre 100 nm et 2 µm et séparer consécutivement le silicium au moyen d'un procédé de séparation orienté sur le substrat structuré périodique, dans lequel comme substrat un matériau stable jusqu'à au moins 570 °C est utilisé et la structure est générée avec ces régions/flancs plats et raides revenant périodiquement, dans lequel le silicium est séparé avec une épaisseur dans la plage de 0,2 à 0,3 fois la constante de réseau a en présence d'une température de substrat allant jusqu'à 400 °C sur le substrat structuré périodique et **caractérisé en ce que** la couche de silicium séparée est ensuite traitée thermiquement au moyen d'une cristallisation en phase solide à des températures comprises entre 570 °C et 1400 °C sur un petit nombre de minutes jusqu'à plusieurs jours.

2. Procédé selon la revendication 1, **caractérisé en ce que** la couche Si est gravée sélectivement par attaque chimique en voie chimique humide au moyen d'une cristallisation en phase solide au moyen de l'élimination des régions Si poreuses générées suivant le traitement thermique.

3. Procédé selon au moins une des revendications précédentes, **caractérisé en ce qu'** un substrat de verre est employé comme substrat.

4. Procédé selon la revendication 1, **caractérisé en ce que** l'évaporation par faisceau d'électrons est employée comme procédé de séparation orienté.
